# EUROPEAN PATENT SPECIFICATION

(11) **EP 3 971 997 B1**
(45) Date of publication and mention of the grant of the patent: **05.07.2023**
(21) Application number: 20382836.3
(22) Date of filing: 22.09.2020
(51) Int. Cl.: H01L 31/115, H01L 31/117, H01L 31/118

(54) **LOW-PENETRATING PARTICLES LOW-GAIN AVALANCHE DETECTOR**
LOW-GAIN-LAWINENDETEKTOR FÜR PARTIKEL MIT NIEDRIGEM DURCHDRINGUNGSGRAD
DÉTECTEUR D'AVALANCHE À FAIBLE GAIN DE PARTICULES À FAIBLE POUVOIR PÉNÉTRANT

(43) Date of publication of application: 23.03.2022
(73) Proprietor: Consejo Superior de Investigaciones Científicas (CSIC), 28006 Madrid (ES); Österreichische Akademie der Wissenschaften, 1010 Wien (AT)
(72) Inventor: PELLEGRINI, Giulio, 08193 Cerdanyola del Vallès (Bellaterra) BARCELONA (ES); HIDALGO VILLENA, Salvador, 08193 Cerdanyola del Vallès (Bellaterra) BARCELONA (ES); FLORES GULL, David, 08193 Cerdanyola del Vallès (Bellaterra) BARCELONA (ES); KHALID, Waleed, 1010 Wien (AT); VALENTAN, Manfred, 1010 Wien (AT)
(74) Representative: Pons

(56) References cited:
- FERNANDEZ-MARTINEZ P ET AL: "Low Gain Avalanche Detectors for high energy physics", 2015 10TH SPANISH CONFERENCE ON ELECTRON DEVICES (CDE), IEEE, 11 February 2015 (2015-02-11), pages 1-4, XP032764670, DOI: 10.1109/CDE.2015.7087475 [retrieved on 2015-04-16]
- MOFFAT N. ET AL: "Low Gain Avalanche Detectors (LGAD) for particle physics and synchrotron applications", JOURNAL OF INSTRUMENTATION, vol. 13, no. 03, 1 March 2018 (2018-03-01) , pages C03014-C03014, XP055776726, GB ISSN: 1748-0221, DOI: 10.1088/1748-0221/13/03/C03014
- WU K ET AL: "Design of Low Gain Avalanche Detectors (LGAD) with 400 keV ion implantation energy for multiplication layer fabrication", NUCLEAR INSTRUMENTS & METHODS IN PHYSICS RESEARCH. SECTION A, ELSEVIER BV * NORTH-HOLLAND, NL, vol. 984, 20 August 2020 (2020-08-20), XP086297244, ISSN: 0168-9002, DOI: 10.1016/J.NIMA.2020.164558 [retrieved on 2020-08-20]

## Description

### OBJECT OF THE INVENTION

The object of the invention is a low-penetrating particles low-gain avalanche detector with a layered structure, which has the capacity to detect low-penetrating radiation or particles, a fine time resolution and low-noise, and that is also able to operate at room temperature.

### BACKGROUND OF THE INVENTION

Silicon radiation detectors, based on the PIN diode, are well established in high-energy physics experiments. The PIN diode, operated with an external reverse bias in full depletion, produces a signal proportional to the energy deposited by the incident radiation.

Silicon photodetectors are for example widely used at synchrotron facilities as X-ray detectors or at large-scale particle physics experiments as particle detectors. Silicon photodetectors are used due to their outstanding features, including their compact size, high quantum efficiency for a wide wavelength range, and high spatial resolution defined by the diode segmentation as either pads, strips or pixels.

In order to detect low-penetrating particles (e.g. low energy protons, electrons and/or neutrons) and low-energy X-rays (light particles, photons) the Avalanche Photodiode (APD) was developed. This type of detector exhibits an internal signal amplification with a gain proportional to the applied bias voltage, with good uniformity across large detection areas. Operation of such a device in the linear region provides a signal output proportional to the absorbed energy, with a gain factor between 10 and 100, allowing detection of low intensity signals, even down to a few photons. However, there is noise associated with the multiplication process, which can distort the signal-to-noise ratio, moreover the leakage current levels associated with APDs are far too high to be compatible with modern hybrid pixel readout systems used in particle physics and hybrid pixel detectors.

The modification of the doping levels in the APD enabled the production of a device with a lower gain, in the region of 5 to 10, which is operated in the linear mode for a proportional response. Such devices are known as Low Gain Avalanche Detectors (LGAD).

They are operated at a low voltage and therefore require a high resistivity silicon substrate (5-10 kΩcm) to achieve full depletion. The lower gain reduces noise and detector gain dependence on device temperature and applied bias voltage compared to standard APDs. The diode can be segmented in the same fashion as standard PIN detectors as the low gain avoids crosstalk. Hybrid pixel detectors can therefore be fabricated that enable the detection of low-energy X-rays and produce signals below the noise floor of the electronics.

The LGAD design enables the detection of sub-nanosecond signals produced by minimum ionising particles, where the ionisation is produced uniformly as a function of depth in the detector. For an LGAD with a gain of 10, if the LGAD substrate is thinned by one order of magnitude compared to a standard PIN silicon detector, the same total signal charge will be produced from a minimum ionising particle. However, the collection time will be decreased by one order of magnitude.

Additionally, inverted Low Gain Avalanche Detectors (iLGAD) are known from the state of the art. iLGAD have an APD (Avalanche Photo Diode) structure in the backside contact, while the segmented front surface is created with an ohmic contact. iLGAD are P-on-P position-sensitive-detectors, with low signal amplification and a uniform electric field all along the device area that guarantees the same signal amplification wherever a particle passes through the sensitive bulk.

The technology is repeatable and well controlled. However, it is not able to detect ions, charged particles or radiation with low penetration depths, i.e. penetration depths smaller than one micrometre.

The document "Low Gain Avalanche Detectors for high energy physics", P. Fernandez-Martinez et al., 2015 10TH SPANISH CONFERENCE ON ELECTRON DEVICES (CDE), IEEE, 11-02-2015, discloses a high penetrating particles LGAD with a n+ electrode, a p-type multiplication layer, and a p-substrate, where the particles are absorbed in the substrate and where the corresponding generated carriers (electrons) are amplified in the high field multiplication layer.

### DESCRIPTION OF THE INVENTION

A low-penetrating particle is understood to be a particle with a penetration depth in silicon below 1 micrometre. When attempting to detect the signal of a low-penetrating particle, a sensor faces three distinct requirements: firstly, non-active layers at the surface need to be thin, secondly the Charge Collection Efficiency (CCE) needs to be high at the surface, and thirdly a readout needs to have a high Signal-Noise Ratio (SNR).

Regarding the first requirement, semiconductor sensors always have non-active layers on their surfaces for protection from the environment. These non-active layers have to be made as thin as possible, to allow the low-penetrating particle to reach the sensitive layer of the sensor in the first place. But even so, a significant part of the primary particle's energy is deposited in the non-active layers and cannot be measured. So, the thickness and composition of the non-active layers define the lower energy limit of the sensor.

Regarding the second requirement, the surface of a silicon substrate (beneath the non-active layers) has a higher defect density than the bulk, and is usually heavily doped to form a field stop. So, the electron-hole pairs created from the energy deposited in the silicon surface region face a higher probability for recombination, thus further reducing the measurable signal. This is manifested in a CCE that is typically significantly lower than 1 close to the silicon surface. However, a sensor with high detection efficiency should have a CCE of 1 close to the surface.

Regarding the third requirement, the remaining signal charge can easily be an order of magnitude lower than the signal of a Minimum lonising Particle (MIP). Thus, a readout with a sufficiently high SNR is of paramount importance.

Especially for low-penetrating particles, like low-energy protons, the signal in the sensor is created close to the sensor's surface, most of it in a depth smaller than 1 micrometre. In conventional silicon sensors, the non-active layers at the surface are a lot thicker than that.

The proposed low-penetrating particles low gain avalanche detector (pLGAD) accommodates these special requirements of low-penetrating particles by comprising a thin entry region, in the order of 15 nanometres, preferably made of aluminium, aluminium oxide or silicon nitride. The polarity of a signal-collecting electrode is n-type, such that the primary electrons drift to the readout region crossing a multiplication layer. This also means inversion of the polarity of the silicon substrate, to keep the p-n junction and thus the multiplication layer at the entry region. The p-n-junction and the multiplication layer are moved into the bulk, away from the entry region and a thin p-type absorption layer is introduced.

Therefore, the low-penetrating particles low gain avalanche detector (pLGAD) of the present invention allows the detection of ions, charged particles or radiation with low penetration depth (i.e. smaller than one micrometre). Particularly, it comprises a multi-layered structure that combines an ultra-shallow entry region with a linear multiplication layer and low capacitance with the possibility of a fine segmentation (few micrometres) of the electrodes at the readout region.

In the pLGAD detector, only signals created close to the entry region are amplified. This makes this detector concept less interesting for High Energy Particles applications, but perfectly suited for low-energy physics experiments and respective applications in the field of material and medical science, testing or diagnosis. Note that in this pLGAD detector concept most of the detector's intrinsic leakage current remains unamplified, because this current is created in the bulk of the material, and only the holes cross the multiplication layer. So, the pLGAD detector concept makes clever use of two systematic asymmetries to detect low-penetrating particles: the signal is created only close to the surface (entry region) on the one hand, and the fact that only electrons are multiplied on the other hand.

This detector will find applications in fields such as neutron physics, ion physics, medical physics, space research, synchrotron detectors and quantum technology, for the detection of low-energy protons, electrons, neutrons and/or X-rays.

Specifically, the detector comprises a multi-layered structure with five main regions: an entry region, a low-penetrating particle detection region (p-doped region), a high-penetrating particle detection region (n-doped region), a readout region and a periphery region.

The entry region faces a radiation source, receiving a variety of particles. It can comprise a protective coating, and a p++ shallow field stop doping, facing the radiation source or positioned beneath the protective coating, of tens of nanometres of thickness.

The low-penetrating particles detection region is positioned beneath the entry region and comprises a p absorption layer, positioned beneath the p++ shallow field stop, and an n multiplication layer, positioned beneath the p absorption layer, of approximately 1 to 5 micrometre thickness.

The high-penetrating particles detection region is situated directly beneath the low-penetrating particles detection region, still close to the entry region, and comprises an n-- silicon substrate, following the n multiplication layer, of approximately 10 to 1000 micrometre thickness.

The device also comprises a readout region, contacting the high-penetrating particles detection region, which can comprise pad, pixel or strip electrodes. The electrodes comprise, in turn, n++ contacts, in contact with the n-- silicon substrate, and metal contacts , connected to the n++ contacts.

The readout region can additionally comprise p+ stops, alternating with the strip electrodes and in contact with the n-- silicon substrate.

Finally, the device also comprises a periphery region, which in turn can comprise one or more metal contacts, joined to the protective coating; one or more metal contacts, joined to the p++ shallow field stop doping, that allow to put the p++ shallow field stop doping on a defined electric potential; a silicon oxide layer, positioned beneath the protective coating; and a p+ termination doping, positioned laterally on both sides of the p++ shallow field stop,

The material polarity of the pLGAD makes the primary electrons, created by the incoming particle, drift to the readout region. Thus, the multiplication acts on the signals created in the low-penetrating particles detection region only.

By its design and its application to low-penetrating particles, the pLGAD has many interesting advantageous properties:
- Noise behaviour and background rejection can be optimized by choosing the detector thickness appropriately.
- The SNR for low-penetrating particles is increased without drawbacks.
- The current pulse shape allows for fast timing.
- Operation at room temperature is feasible.
- Flexibility in choosing the energy range of the incoming particles for full amplification.
- The multiplication layer is compatible with many readout schemes.

The following paragraphs go into detail about the listed advantages:
Noise behaviour and background rejection can be optimized by choosing the detector thickness appropriately. The primary signal is created close to the surface. Therefore, and in contrast to High Energy Particles, the total charge depends on the incoming particle's energy only, and not on the detector's thickness. This means that the thickness of a pLGAD can be chosen freely within the limits of the production technologies, for optimizing e.g. the noise behaviour or the response to background particles.

The thickness influences the pulse duration and amplitude, and the load capacitance seen by the readout electronics. On top of that, a thin pLGAD (below 100 micrometres) would allow high-energetic particles to pass through and suppress their signal height, and a thick pLGAD (above 1.5 millimetres) would allow spectroscopic measurements of deep penetrating particles by completely stopping them within the sensor.

The SNR is increased without drawbacks. With pLGAD's choice of polarities, only the ionization electrons (primary and secondary electrons) created by the incoming low-penetrating particles are multiplied. Electrons created in the bulk, like from a traversing background particle or by thermal excitation, drift away from the multiplication layer. This means that for traversing particles, a pLGAD behaves like a planar sensor.

The leakage current and its corresponding noise are not amplified. This means that the SNR for low-penetrating particles is increased by the gain, without drawbacks compared to a planar sensor.

The current pulse shape allows for fast timing. The primary electrons traverse the pLGAD thickness on a straight path. In contrast to competing technologies, in a pLGAD sensor the primary electrons traverse the thickness of the detector on the shortest possible path. Also, only the electrons cross the detector, and not the holes. This leads to a short pulse duration with a fast-rising edge, which is beneficial for timing.

Operation at room temperature is feasible. High detection efficiencies can be achieved by detectors which store the signal charge and read it repeatedly. This, however, is a time-consuming process, during which the leakage current distorts the signal. Consequently, cooling is a must for those sensors. In contrast, a pLGAD can be operated at room temperature, while achieving high detection efficiencies.

The incoming particle's energy range for full amplification can be adjusted. The composition of the entry region defines the minimum energy of a low-penetrating particle to be detectable. In contrast, the depth in which the multiplication happens defines the upper energy an incoming particle may have, while all of its signal is multiplied. After all, to be fully amplified, an incoming particle has to be completely stopped in the p absorption layer.

The multiplication layer is compatible with many readout schemes. Signal creation and readout happen on different faces of the detector. So, a pLGAD can be realized with different geometries for a planar readout electrode, e.g., in form of a silicon microstrip sensor or a pixel layout, or any other readout scheme that can be implemented with n-type electrodes in an n-type substrate. This includes, inter alia, readout schemes that integrate the first amplification stage into the detector, like HV-CMOS sensors.

If a pLGAD is made with a planar readout electrode, it is just as easy to operate as other planar sensors. Or put differently, a pLGAD-like multiplication layer can in principle be added to existing sensor technologies to enhance their detection efficiency for low-penetrating particles.

### DESCRIPTION OF THE DRAWINGS

To complement the description being made and in order to aid towards a better understanding of the characteristics of the invention, in accordance with a preferred example of practical embodiment thereof, a set of drawings is attached as an integral part of said description wherein, with illustrative and non-limiting character, the following has been represented:
Figure 1.- Shows a first embodiment of the low-penetrating particles low gain avalanche detector, in a cross section of one detector half.
Figure 2.- Shows a second embodiment of the low-penetrating particles low gain avalanche detector impacted by low-penetrating radiation in a cross section.
Figure 3.- Shows a simplified cross section of the device with the electric field profile.
Figure 4.- Shows the comparison of the current pulses from a 15 keV proton (top) and a minimum ionizing particle (MIP, bottom), both for normal incidence of the projectile particle.
Figure 5.- Shows the current pulse created by a 15 keV proton as a function of time, zoomed into the first peak of figure 4.
Figure 6.- Shows the undetected protons with different energies at normal incidence, as function of the detection threshold of the data acquisition system in primary electrons.

### PREFERRED EMBODIMENT OF THE INVENTION

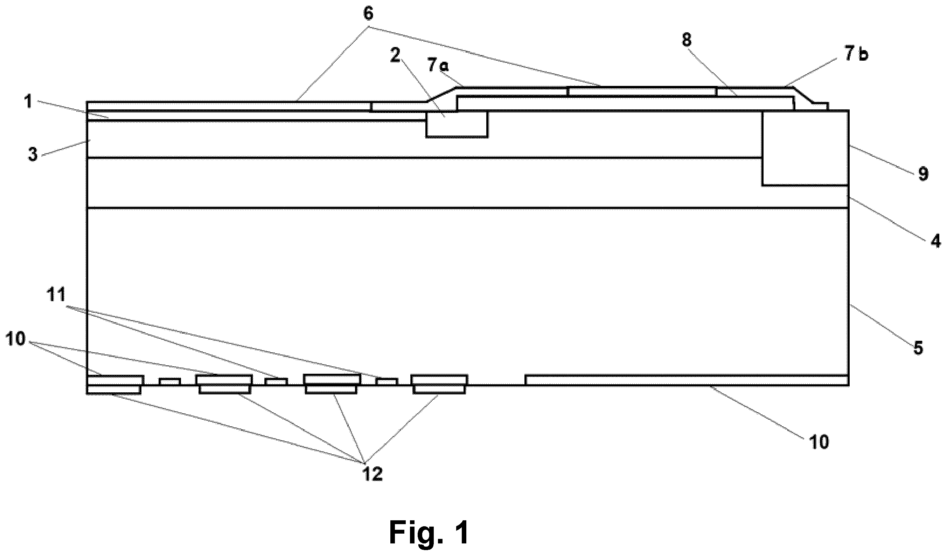

With the help of figures 1 to 6, a preferred embodiment of the present invention is described below.

As shown in figure 1, the low-penetrating particles low gain avalanche detector comprises a multi-layered structure with:
- an entry region, which comprises:
   ∘ a protective layer (6),
   ∘ a p++ shallow field stop (1), positioned beneath the protective layer (6) with tens of nanometres of thickness,
- a low-penetrating particles detection region, which comprises:
   ∘ a p absorption layer (3), positioned beneath the p++ shallow field stop (1),
   ∘ a multiplication layer (4), positioned beneath the p absorption layer (3), of approximately 1 to 5 micrometre thickness,
- a high-penetrating particles detection region, which comprises:
   ∘ a n-- silicon substrate (5), following the n multiplication layer (4), of approximately 10 to 1000 micrometre thickness,
- a readout region, which comprises:
   ∘ pixel or strip electrodes, following the high-penetrating particles detection layer, which comprise:
      ▪ n++ contacts (10), in contact with the n-- silicon substrate (5),
      ▪ additional metal contacts (12), connected to the n++ contacts (10),
   ∘ p+ stops (11), alternating with the strip electrodes and in contact with the n-- silicon substrate (5), and
- a periphery region, which comprises:
   ∘ one or more n++ ohmic contacts (9), positioned next to the p absorption layer (3),
   ∘ metal contacts (7a, 7b), wherein a first metal contact (7a) is joined to the p++ shallow field stop (1), and one or more second metal contacts (7b) are joined to the n++ ohmic contacts (9),
   ∘ a silicon oxide layer (8), positioned beneath the protective layer (6), and
   ∘ a p+ termination doping (2), positioned laterally on both sides of the p++ shallow field stop (1).

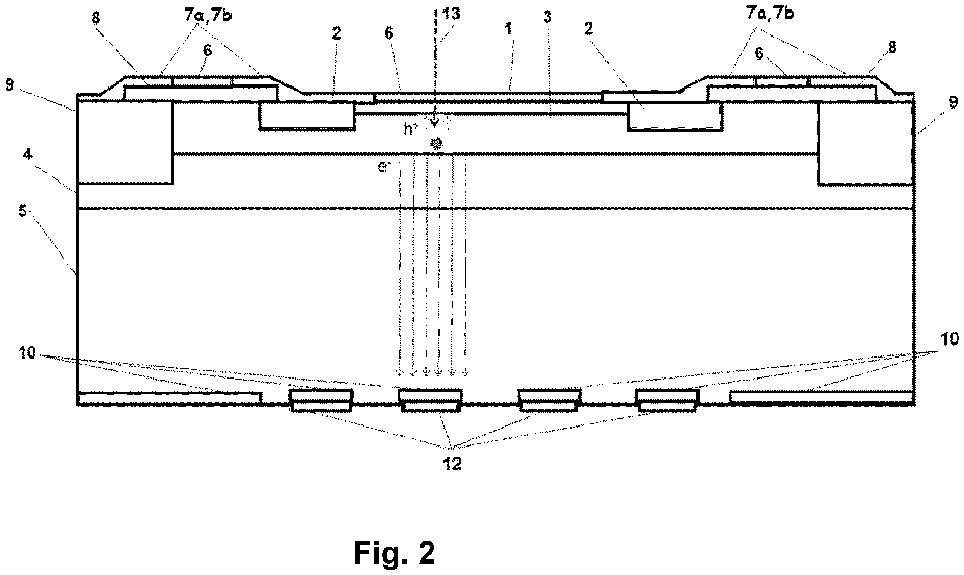

As shown in figure 2, low-energy protons (or other low-penetrating particles or radiation) coming from a radiation source (13) illuminate the detector at the entry region. The protons will go through the protective layer (6), which has been deposited for example by atomic layer deposition to obtain for example *Al, Al₂O₃,* or low-pressure chemical vapour deposition methods to obtain for example *Si₃N₄.*

The protective layer (6) is used to protect the surface of the detector from humidity or scratches and insures long-term electrical stability under operation at high bias voltages. The protective layer (6) can act as an antireflective coating for visible, ultraviolet and infrared radiation. The protective layer (6) can also be used as conversion layer for incoming neutrons. The minimum thickness deposited is in the order of a few nanometres and can be optimized for different radiation wavelengths.

The p+ termination doping (2) of the periphery region must be formed laterally next to the p++ shallow field stop, in order to avoid electric field peaks and ensure stable high-voltage operation.

Incoming protons will have to go also through the high-doped region, the p++ shallow field stop (1), and therefore it must be kept as thin as possible in order to avoid the recombination of the electron-holes generated by them. The p absorption layer (3) can be created for example by ion implantation and a variety of dopants (B, Ga, Al).

Particularly, the p++ shallow field stop's (1) depth must be less than 100 nanometres, since low-energy proton particles will penetrate in the order of several hundred nanometres. Therefore, the p absorption layer (3) of for example 1 micrometre thickness is positioned underneath to absorb all the energy deposited by the proton (or other low-penetrating particles). In order to get a multiplied signal of the collected charge, the low-penetrating particle detection section, and n-type multiplication layer, is positioned above the high-penetrating particle detection layer, leading to a final triple doping profile.

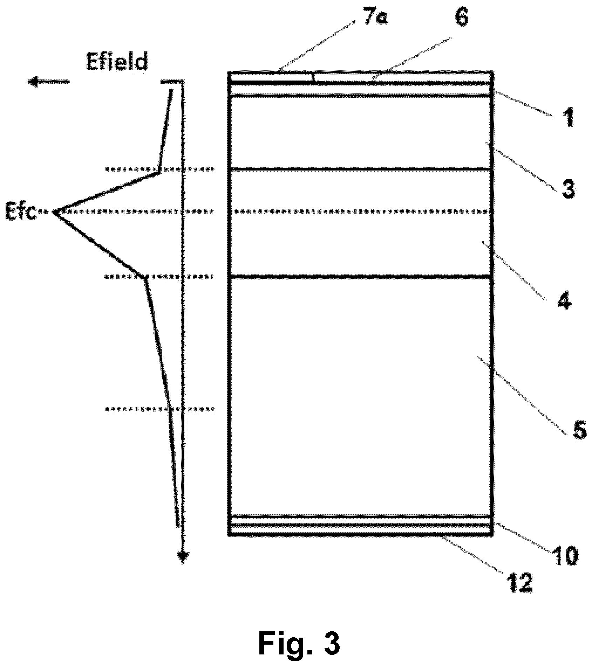

Thus, a high electric field, i.e. larger than > 3.10⁵ *V*/*cm,* shown in figure 3, is created at the pin junction, where the primary electrons from the created electron-hole pairs (*e*⁻/*h*⁺) will be multiplied.

The p absorption layer (3) and the n multiplication layer (4) may be created by ion implantation or by epitaxial growth. The control of the doping profiles and shapes is important for achieving a proper electron gain and avoiding early breakdowns.

The thickness of the p absorption layer (3) in front of the n multiplication layer (4), which form the p-n junction, can be adapted to match the penetration depth of the incoming particles or radiation.

The n-- silicon substrate (5) decreases the capacitance and improves the stability with respect to changes in bias voltage, which directly relates to the capacitance. The thickness of the high-penetrating particle detection layer is designed to reduce the input capacitance to the readout electronics and therefore the noise. Possible values of its thickness will range from 10 micrometres to 1000 micrometres (or even above, if the technology permits). The thickness of the high-penetrating particle detection layer defines the minimum operation voltage of the detector, since for getting the minimum capacitance, the full substrate must be depleted from charges.

The readout region of the detector, which may be on its backside, is segmented with n++ contacts (10) connected to readout electronics via additional metal contacts (12). The n++ contacts (10) can be formed, as shown in figure 2, with phosphorus or equivalent dopants by ion implantation and with different geometries such as pads, pixels or strips with different sizes. In principle, any readout scheme compatible with n-in-n contacts can be used, although it depends on the concentration of the n multiplication layer (4) and of the p absorption region (3). That includes, inter alia, monolithic pixels like the ones used in HV-CMOS sensors.

Preliminary simulation results show that the avalanche process relates to the doping concentration of the p absorption region (3) and the n multiplication region (4) of the proposed structure. In this sense, it is possible to tune the amplitude of the electric field maximum in order to adjust its electrical performance, optimizing the gain versus the anode voltage for increasing its linear evolution before the breakdown voltage.

In a planar sensor, the measurable signal is a current pulse created by the drift of the charge carriers towards the electrodes. We simulate the expected current pulse in the detector of the invention. We separately put out the current pulses for primary electrons, primary holes, secondary electrons, secondary holes and the summed current pulse.

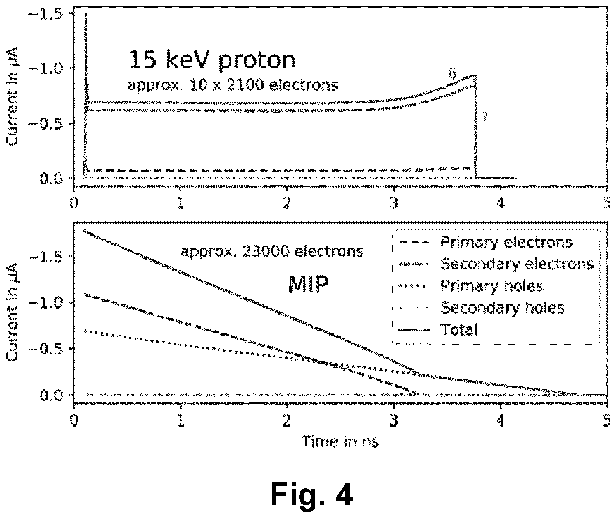

Figure 4 shows the overlay of these current pulses created by a 15 keV proton (top, low-penetrating) and a MIP (bottom, traversing the whole sensor thickness), both with normal incidence. Only signals close to the entry region are amplified. For a high-energetic, traversing particle, e.g., a MIP, a pLGAD behaves like a classic planar sensor.

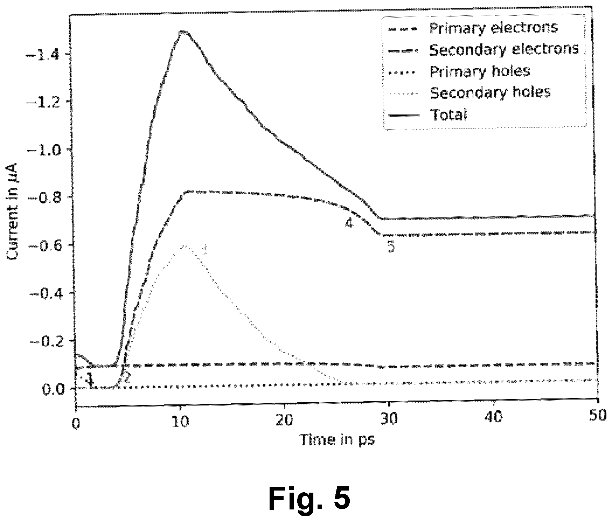

Figure 5 shows a zoom into the current pulse created by a 15 keV proton. The most important features of the pulse shape are (sorted chronologically):
- Point 1 (1 ps): A small dip, when the primary holes are collected at the entry region (loosely dotted).
- Point 2 (4 ps): A sharp increase, when the primary electrons are multiplied and secondary electrons are created (densely dashed).
- Point 3 (11 ps): A drop, when the secondary holes are collected at the entry region (densely dotted).
- Point 4 (26 ps): A dropping shoulder, when the secondary electrons leave the highly doped multiplication layer (densely dashed). This marks the end of the initial peak.
- Point 5 (30 ps): A plateau, when the primary and secondary electrons drift to the readout region in one compact package (loosely dashed and densely dashed).
- Point 6 (3 ns, shown in figure 4): A slight increase, when the primary and secondary electrons reach the vicinity of the readout electrode and experience a higher weighting field.
- Point 7 (3.7 ns, shown in figure 4): A sharp drop, when the ionization electrons (primary and secondary electrons) are collected at the readout electrode.

The exact shape of the current pulse depends on many things, like the doping profiles, the depth of the p-n-junction and the thickness of the multiplication layer. The current pulse shown in figure 5 is the result of a simplified simulation setup; realistic doping profiles will lead to a more washed-out shape. However, the main features of the pulse shape will still be present.

The pLGAD concept targets a specific niche: ultra-low-noise silicon sensor, position-resolving, with thin entry region for back-illumination. This niche is also served by two other silicon technologies: Silicon drift detector (SDD) and DEpleted P-channel Field Effect Transistor (DEPFET).

SDDs are a common choice in low-energy physics, especially where large areas have to be instrumented, and only a coarse position resolution is required. A comparison with a pLGAD would not be fair, because an SDD shines for large area sensing elements in the order of square centimetres. This size is a lot larger than the target position resolution of pLGAD sensors, so we have no directly comparable noise estimations for the SDD. Consequently, we mention the SDD for completeness, but do not present a detailed comparison of respective performances.

DEPFET sensors originate from High Energy Particles research and are available with small pixel sizes, down to tens of micrometres. In combination with drift rings (like on an SDD), larger pixel sizes are possible.

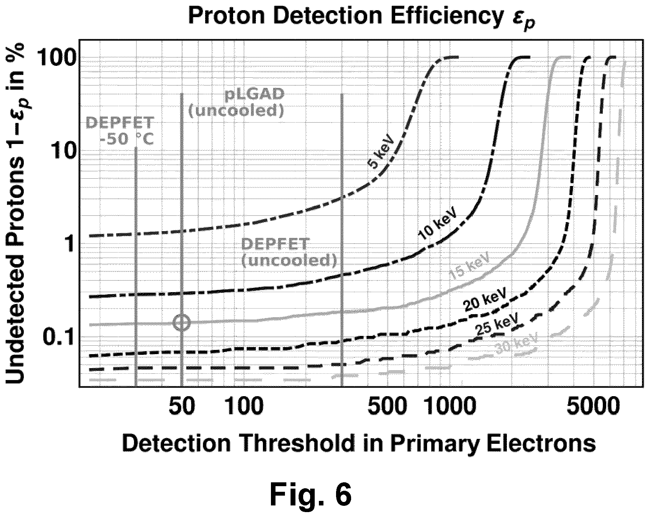

We can directly compare the performance of the pLGAD and the DEPFET in figure 6 for a pixel size of 0.4 x 1.6 square millimetres. A DEPFET sensor with appropriate pixel geometry reaches a detection threshold of below 30 primary electrons, if cooled to -50°C. The pLGAD is limited to above 50 primary electrons, but at room temperature.

Both DEPFET and SDD technologies introduce a number of complications: the sensors are intricate, and therefore expensive, and require at least 7 (5 for SDD) different operation voltages. For a DEPFET sensor, cooling is mandatory to keep the leakage current and its corresponding noise low, and thus increase the detection efficiency (see figure 6). In addition, the DEPFET technology involves several different custom readout chips, and has a relatively low frame rate in the order of microseconds.

In contrast, the proposed pLGAD can be operated with only one supply voltage, works with commercial readout systems that can read planar sensors, can be operated at room temperature, has a high intrinsic time resolution and is a lot cheaper, because of the simple planar production process.

Figure 6 shows the percentage of undetected protons as function of the detection threshold of the data acquisition system, for different proton energies at normal incidence, and with a protective layer (6) of 15 nm. For the sake of clarity, figure 6 is without error bars, but due to statistical variation of the Monte Carlo method, the represented values can be higher or lower. Protons can go undetected due to backscattering, when they deposit too little energy in the active region of the detector, or when they are completely stopped in the non-active layer.

For proton energies of 15 keV, the pLGAD outperforms an uncooled DEPFET sensor with the same pixel layout, and achieves almost the same detection efficiency like a cooled one. A proton loss in the order of 0.15 % (or a detection efficiency of 99.85 %) seems possible, as a best-case scenario.

## Claims

1. A low-penetrating particles low gain avalanche detector with a multi-layered structure, configured to receive particles from a radiation source (13), wherein the detector comprises:
- an entry region, configured to receive the particles from the radiation source (13), and that comprises:
∘ a p++ shallow field stop (1), and
- a low-penetrating particles detection region, which comprises the following layers, in increasing depth:
∘ a p absorption layer (3), positioned beneath the p++ shallow field stop (1),
∘ an n multiplication layer (4), positioned beneath the p absorption layer (3),
- a high-penetrating particles detection region, which comprises:
∘ an n-- silicon substrate (5), following the n multiplication layer (4), below the low-penetrating particles detection region,
- a readout region, contacting the high-penetrating particles detection region, and
- a periphery region, which comprises:
∘ a p+ termination doping (2), positioned laterally on both sides of the p++ shallow field stop (1), and
∘ one or more metal contacts (7a), joined to the p++ shallow field stop (1).

2. The detector according to claim 1, wherein the entry region additionally comprises a protective layer (6), positioned over the p++ shallow field stop (1).

3. The detector according to claim 2, wherein the protective layer (6) is a conversion layer for incoming neutrons.

4. The detector according to claim 2, wherein the periphery region additionally comprises a silicon oxide layer (8), positioned beneath the protective layer (6).

5. The detector according to claim 1, wherein the p++ shallow field stop (1) is within the range of tens of nanometres of thickness.

6. The detector according to claim 1, wherein the n multiplication layer (4) is within the range of 1 to 5 micrometre thickness.

7. The detector according to claim 1, wherein the n-- silicon substrate (5) is within the range of 10 to 1000 micrometre thickness.

8. The detector according to claim 1, wherein the periphery region additionally comprises n++ ohmic contacts (9), positioned on both sides of the P absorption layer (3).

9. The detector according to claim 1, wherein the readout region additionally comprises segmented electrodes, following the high-penetrating particles detection layer, opposite to the low-penetrating particles detection layer.

10. The detector according to claim 9, wherein the segmented electrodes comprise n++ contacts (10), in contact with the n-- silicon substrate (5), and additional metal contacts (12), connected to the n++ contacts (10).

11. The detector according to claim 9, wherein the readout region additionally comprises p+ stops (11), alternating with the segmented electrodes and in contact with the n-- silicon substrate (5).

## Patentansprüche

1. Low-Gain-Lawinendetektor für Partikel mit niedrigem Durchdringungsgrad mit einer mehrschichtigen Struktur, der dazu ausgelegt ist, Partikel von einer Strahlungsquelle (13) zu empfangen, wobei der Detektor Folgendes umfasst:
- einen Eintrittsbereich, der dazu ausgelegt ist, die Partikel von der Strahlungsquelle (13) zu empfangen, und der Folgendes umfasst:
o eine flache p++-Feldblende (1) und
- einen Detektionsbereich für Partikel mit niedrigem Durchdringungsgrad, der mit zunehmender Tiefe die folgenden Schichten umfasst:
∘ eine p-Absorptionsschicht (3), die unter der flachen p++-Feldblende (1) positioniert ist,
∘ eine n-Multiplikationsschicht (4), die unter der p-Absorptionsschicht (3) positioniert ist,
- einen Detektionsbereich für Partikel mit hohem Durchdringungsgrad, der Folgendes umfasst:
∘ ein n---Siliziumsubstrat (5), das der n-Multiplikationsschicht (4) folgt, unter dem Detektionsbereich für Partikel mit niedrigem Durchdringungsgrad,
- einen Auslesebereich, der den Detektionsbereich für Partikel mit hohem Durchdringungsgrad berührt, und
- einen Peripheriebereich, der Folgendes umfasst:
∘ eine p+-Abschlussdotierung (2), die seitlich auf beiden Seiten der flachen p++-Feldblende (1) positioniert ist, und
∘ einen oder mehrere Metallkontakte (7a), die mit der flachen p++-Feldblende (1) verbunden sind.

2. Detektor nach Anspruch 1, wobei der Eintrittsbereich zusätzlich eine Schutzschicht (6) umfasst, die über der flachen p++-Feldblende (1) positioniert ist.

3. Detektor nach Anspruch 2, wobei die Schutzschicht (6) eine Konversionsschicht für ankommende Neutronen ist.

4. Detektor nach Anspruch 2, wobei der Peripheriebereich zusätzlich eine Siliziumoxidschicht (8) umfasst, die unter der Schutzschicht (6) positioniert ist.

5. Detektor nach Anspruch 1, wobei die flache p++-Feldblende (1) eine Dicke von mehreren Dutzend Nanometern aufweist.

6. Detektor nach Anspruch 1, wobei die n-Multiplikationsschicht (4) eine Dicke von 1 bis 5 Mikrometern aufweist.

7. Detektor nach Anspruch 1, wobei das n---Siliziumsubstrat (5) eine Dicke von 10 bis 1000 Mikrometern aufweist.

8. Detektor nach Anspruch 1, wobei der Peripheriebereich zusätzlich ohmsche n++-Kontakte (9) umfasst, die auf beiden Seiten der P-Absorptionsschicht (3) positioniert sind.

9. Detektor nach Anspruch 1, wobei der Auslesebereich zusätzlich segmentierte Elektroden umfasst, die der Detektionsschicht für Partikel mit hohem Durchdringungsgrad folgen, gegenüber der Detektionsschicht für Partikel mit niedrigem Durchdringungsgrad.

10. Detektor nach Anspruch 9, wobei die segmentierten Elektroden n++-Kontakte (10), in Kontakt mit dem n---Siliziumsubstrat (5), und zusätzliche Metallkontakte (12), die mit den n++-Kontakten (10) verbunden sind, umfassen.

11. Detektor nach Anspruch 9, wobei der Auslesebereich zusätzlich p+-Blenden (11) umfasst, die sich mit den segmentierten Elektroden abwechseln und mit dem n---Siliziumsubstrat (5) in Kontakt sind.

## Revendications

1. Détecteur d'avalanche à faible gain de particules à faible pénétration avec une structure multicouche, configuré pour recevoir des particules d'une source de rayonnement (13), dans lequel le détecteur comprend :
- une zone d'entrée, configurée pour recevoir les particules de la source de rayonnement (13), et qui comprend :
∘ une butée de champ peu profond p++ (1), et
- une zone de détection de particules à faible pénétration, qui comprend les couches suivantes, en profondeur croissante :
∘ une couche d'absorption p (3), positionnée sous la butée de champ peu profond p++ (1),
∘ une couche de multiplication n (4), positionnée sous la couche d'absorption p (3),
- une zone de détection de particules à haute pénétration, qui comprend :
∘ un substrat de silicium n-- (5), suivant la couche de multiplication n (4), en dessous de la zone de détection de particules à faible pénétration,
- une zone de lecture, venant en contact avec la zone de détection de particules à haute pénétration, et
- une zone périphérique, qui comprend :
∘ un dopage de terminaison p+ (2), positionné latéralement des deux côtés de la butée de champ peu profond p++ (1), et
∘ un ou plusieurs contacts de métal (7a), joints à la butée de champ peu profond p++ (1).

2. Détecteur selon la revendication 1, dans lequel la zone d'entrée comprend en outre une couche protectrice (6), positionnée au-dessus de la butée de champ peu profond p++ (1).

3. Détecteur selon la revendication 2, dans lequel la couche protectrice (6) est une couche de conversion pour neutrons entrants.

4. Détecteur selon la revendication 2, dans lequel la zone périphérique comprend en outre une couche d'oxyde de silicium (8), positionnée sous la couche protectrice (6).

5. Détecteur selon la revendication 1, dans lequel la butée de champ peu profond p++ (1) est dans la plage de dizaines de nanomètres d'épaisseur.

6. Détecteur selon la revendication 1, dans lequel la couche de multiplication n (4) est dans la plage de 1 à 5 micromètres d'épaisseur.

7. Détecteur selon la revendication 1, dans lequel le substrat de silicium n-- (5) est dans la plage de 10 à 1 000 micromètres d'épaisseur.

8. Détecteur selon la revendication 1, dans lequel la zone périphérique comprend en outre des contacts ohmiques n++ (9), positionnés des deux côtés de la couche d'absorption P (3).

9. Détecteur selon la revendication 1, dans lequel la zone de lecture comprend en outre des électrodes segmentées, suivant la couche de détection de particules à haute pénétration, à l'opposé de la couche de détection de particules à faible pénétration.

10. Détecteur selon la revendication 9, dans lequel les électrodes segmentées comprennent des contacts n++ (10), en contact avec le substrat de silicium n-- (5), et des contacts de métal supplémentaires (12), connectés aux contacts n++ (10).

11. Détecteur selon la revendication 9, dans lequel la zone de lecture comprend en outre des butées p+ (11), en alternance avec les électrodes segmentées et en contact avec le substrat de silicium n-- (5).
